# EUROPÄISCHE PATENTSCHRIFT

(11) **EP 3 025 162 B1**
(45) Veröffentlichungstag und Bekanntmachung des Hinweises auf die Patenterteilung: **06.09.2017**
(21) Anmeldenummer: 14741302.5
(22) Anmeldetag: 18.07.2014
(51) Int. Cl.: G01R 33/00, G01R 33/09, G11B 5/31, G11C 29/50

(54) **MEHRKOMPONENTEN-MAGNETFELDSENSOR**
MULTICOMPONENT MAGNETIC FIELD SENSOR
CAPTEUR DE CHAMPS MAGNÉTIQUES À PLUSIEURS COMPOSANTES

(30) Priorität: 22.07.2013 DE 102013107821
(43) Veröffentlichungstag der Anmeldung: 01.06.2016
(73) Patentinhaber: Sensitec GmbH, 35633 Lahnau (DE)
(72) Erfinder: WEBER, Sebastian, 35584 Wetzlar (DE); GLENSKE, Claudia, 35638 Leun (DE); LOREIT, Uwe, 35580 Wetzlar (DE)
(74) Vertreter: Spachmann, Holger
(86) Internationale Anmeldenummer: PCT/EP2014/065524
(87) Internationale Veröffentlichungsnummer: WO 2015/011052

(56) Entgegenhaltungen:
- WO-A1-2012/116933
- DE-A1-102008 041 859
- DE-A1-102009 008 265
- US-A1- 2004 137 275
- US-A1- 2013 141 090
- US-A1- 2013 169 271

## Beschreibung

Die Erfindung betrifft einen Magnetfeldsensor zur Messung von zwei oder drei Komponenten eines Magnetfeldes. Als magnetfeldempfindliche Messelemente können magnetoresistive Widerstandselemente oder Hall-Elemente eingesetzt werden. Die Anordnungen eignen sich für die Messung von Magnetfeldern geringerer Intensität, wie z.B. für die Realisierung eines elektronischen Kompasses.

### STAND DER TECHNIK

Gattungsgemäße Anordnungen der genannten Art sind bekannt. So wird in der DE 10 2009 008 265 eine Anordnung beschrieben, bei der es durch eine geeignete Ausgestaltung von weichmagnetischen Flussführungen möglich ist, mehrere Komponenten eines externen Magnetfeldes zu messen. Dabei wird zur Messung der in der Sensorebene liegenden Komponenten je eine Einheit aus Sensorelement und Flussführung benötigt. Zur Messung der senkrechten Komponente wird ein zusätzliches Sensorelement benötigt, wobei durch eine geeignete Flussführung die senkrechte Komponente des zu messenden Magnetfeldes derart geführt bzw. umgelenkt wird, dass am Ort des Sensors auch eine horizontale, in der SensorEbene liegende Magnetfeld-Komponente ausgebildet wird, die dann von einem Sensorelement erfasst werden kann.

In der DE 10 2008 041 859 wird eine Anordnung zur Messung einer senkrecht zu einer Magnetfeldsensorebene stehenden Z-Magnetfeldkomponente beschrieben, bei der mehrere Sensorelemente zu einer Magnetfeldsensorelement-Einheit zusammengeschaltet und um ein insbesondere kreisförmiges Flussführungselement angeordnet sind. Es wird vorgeschlagen, die senkrechte Z-Magnetfeldkomponente indirekt dadurch zu messen, dass mittels des Flussführungselements auftretende waagerechte, symmetrische Ausgleichs-Magnetfeldkomponenten aufgrund einer Magnetfeldinhomogenität der Z-Magnetfeldkomponente am Außenumfang des Flussführungselements mittels der benachbart zum Flussführungselement angeordneten Sensorelemente bestimmt werden. Weitere Sensorelemente können Magnetfeldkomponenten in der X-/Y-Magnetfeldsensorebene bestimmen, wobei für eine dreidimensionale Feldmessung zumindest drei verschiedene Magnetfeldsensorelement-Einheiten vorgesehen sind. Durch die Verwendung von mehreren Sensorelementen können Verbesserungen hinsichtlich Messgenauigkeit und Störunempfindlichkeit erreicht werden. Nachteilig bei den beschriebenen Lösungen ist der erforderliche Platzbedarf zur Erfassung mehrerer Magnetfeldkomponenten, wie sie bei typischen Kompassanwendungen gefordert ist.

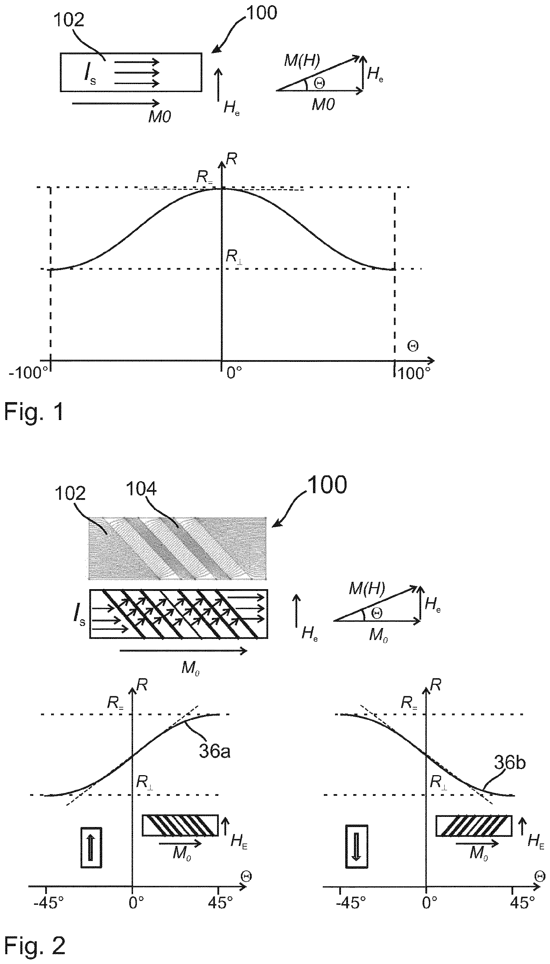

Aus dem Stand der Technik ist zum Design von Magnetfeldsensorvorrichtungen bekannt, sogenannte Barberpolstrukturen, d.h. dünne leitfähige Strukturen auf einem AMR-Messstreifen anzuordnen, die aus extrem leitfähigem Material wie beispielsweise Aluminium, Kupfer, Gold oder Silber bestehen. Die Barberpolstrukturen sind um 45° gegenüber der Längserstreckung des AMR-Widerstandsstreifen ausgerichtet. Ein durch den Widerstandsstreifen fließender Strom wird dabei in eine 45°-Richtung zur Längserstreckung des Streifens gezwungen, so wie es in Fig. 2 dargestellt ist. Hierdurch wird die in Fig. 1 dargestellte Abhängigkeitskurve des Widerstands von Ausrichtung des Stromvektors zum Magnetfeldvektor um 45° verschoben, so dass sie, wie in Fig. 2 dargestellt, in einen linearisierten Bereich überführt werden kann. Abhängig von der Ausrichtung der Barberpolstrukturen ergibt sich eine positive bzw. negative Flanke einer Linearisierung zwischen Widerstand und Größe des zu messenden Magnetfelds.

Magnetfeldsensorvorrichtungen, die auf Barberpolstrukturen beruhen, sind beispielsweise in der DE 344 22 78A1 bekannt. Hierbei sind vier derartige Magnetfeldsensorvorrichtungen mit unterschiedlich ausgerichteten Barberpolstrukturen in einer Wheatstone-Messbrücke zusammengeschaltet, wobei durch ein externes Magnetfeld, das von einer makroskopischen Magnetspule erzeugt wird, eine Vormagnetisierung der inneren Magnetisierung *M*₀ der Widerstandsstreifen hergestellt wird, um eine linearisierte Widerstandsabhängigkeit vom externen Magnetfeld *H*ₑ hervorzurufen.

Eine Verbesserung eines derartigen Designs ist beispielsweise in der DE 43 191 46 C2 beschrieben. Diese schlägt vor, eine Reihe von AMR-Widerstandseinrichtungen mit Barberpolstrukturen entlang eines von einem Flipstrom durchflossenen Leiters anzuordnen, wobei der Flipstromleiter eine Vormagnetisierung *M*₀ in Längsrichtung der AMR-Messstreifen bewirkt. Durch ein Flippen, d.h. eine Umkehrung der inneren Magnetisierung, kann eine Neuausrichtung bzw. Kalibrierung des Widerstandsverhaltens erreicht werden. Die Anordnung ist in der Lage eine Komponente eines externen Magnetfeldes präzise zu messen. Für die Messung der zweiten in der Sensorebene liegenden Komponente ist es ausreichend eine weitere um 90° verdrehte Widerstandseinrichtung vorzusehen. Zur Messung der weiteren Komponente müssen weitere Anordnungen mit entsprechendem zusätzlichem Platzbedarf vorgesehen werden. Zur Bestimmung eines dreidimensionalen Verlaufs eines Magnetfeldes werden in der Regel drei Magnetfeldsensorelement-Einheiten in Form von Wheatstone-Messbrücken vorgesehen, die jeweils um 90° zueinander versetzt werden. Somit kann jede Sensorelement-Messbrücke eine Komponente messen, wobei die Messbrücke in X-, Y- und Z-Richtung ausgerichtet werden muss. Insbesondere die in Z-Richtung, d.h. senkrecht zu einer Chipsubstrat- bzw. PCB-Substrat stehende Anordnung erfordert einen großen Bauraum und eine erhöhte fertigungstechnische Komplexität zur Herstellung eines 3D-Sensors.

In der US 2013/141090 A1 ist eine Magnetfeldsensorvorrichtung beschrieben, die eine Wheatstonebrücke mit zwei Halbbrücken umfasst, wobei jeweils ein Brückenwiderstand jeder Halbbrücke auf einem Flusskonzentrationselement angeordnet ist, um dieses gegen ein äußeres Magnetfeld abzuschirmen. Der jeweils andere Brückenwiderstand ist zwischen den beiden Flusskonzentrationselementen angeordnet, um den Magnetfluss durch den Brückenwiderstand zu erhöhen. Jede Wheatstonebrücke ist zur Messung einer einzelnen Magnetfeldkomponente vorgesehen.

Aus der WO 2012/116933 A1 ist eine 3D-Magnetfeldsensorvorrichtung bekannt, die drei Wheatstonebrücken mit magnetfeldsensitiven Widerständen umfasst, um die drei Komponenten eines Magnetfelds unabhängig voneinander mittels einer einzelnen Wheatstonebrücke zu erfassen. Die Brückenwiderstände jeder Wheatstonebrücke sind an Stirnflächen von halbringförmigen Flusskonzentrationselementen angeordnet, die derart ausgerichtet sind, dass sie den Magnetfluss je nach Komponentenrichtung verstärken oder abschwächen, um eine einzelne Komponente messen zu können.

Die US 2004/137275 A1 betrifft eine 2D-Magnetfeldsensorvorrichtung, die zwei Wheatstonebrücken mit jeweils vier magnetoresistiven Brückenwiderständen umfasst, um mittels jeder Wheatstonebrücke eine Magnetfeldkomponente erfassen zu können. Jeweils zwei Brückenwiderstände jeder Wheatstonebrücke sind auf Flusskonzentrationselementen als Referenzwiderstände angeordnet, und die verbleibenden beiden Brückenwiderstände sind zwischen den Flusskonzentrationselementen zur Erhöhung der Magnetfeldsensitivität vorgesehen. Jede Wheatstonebrücke kann eine Komponente eines Magnetfeldes erfassen.

Durch die US 2013/169271 A1 wird eine gattungsgleiche Magnetfeldsensorvorrichtung zur Erfassung einer einzelnen Magnetfeldkomponente offenbart, die eine Brückenschaltung mit vier magnetoresistiven Brückenwiderständen zur Erfassung einer Magnetfeldkomponente vorschlägt, wobei zwei Brückenwiderstände auf Flusskonzentrationselemente angeordnet sind, um diese gegen ein Magnetfeld abzuschirmen, und die beiden verbleibenden Brückenwiderstände zwischen den Flusskonzentrationselementen angeordnet sind, um die Magnetflussführung zu verbessern.

Ausgehend von dem vorgenannten Stand der Technik ergibt sich das Problem, einen 2D- oder 3D-Sensor bereitzustellen, der einfach herzustellen ist und sowohl eine Magnetfeldkomponente in einer Sensorelementebene als auch eine Komponente senkrecht hierzu bestimmen kann. Eine weitere Aufgabe der Erfindung liegt darin, eine kompakte und störsichere Messung von mehreren Komponenten eines Magnetfeldes zu ermöglichen.

Diese Aufgabe wird mit Anordnungen gemäß dem Hauptanspruch 1 gelöst. Vorteilhafte Weiterbildungen sind in den nachfolgenden Unteransprüchen beschrieben.

### OFFENBARUNG DER ERFINDUNG

Erfindungsgemäß wird eine Magnetfeldsensorvorrichtung zur Bestimmung von zwei oder drei Komponenten eines Magnetfeldes vorgeschlagen, die zumindest eine Wheatstonebrücke mit zwei Halbbrücken umfasst, wobei jede Halbbrücke zumindest zwei Brückenwiderstände umfasst. Zumindest einer der beiden Brückenwiderstände ist ein magnetfeldsensitiver Widerstand mit einer in einer X/Y-Ebene liegenden Empfindlichkeitsrichtung. Symmetrisch zwischen den beiden magnetfeldsensitiven Brückenwiderständen ist ein ferromagnetisches Flusskonzentrationselement angeordnet, das bezüglich einer senkrecht zur X/Y-Magnetfeldsensorebene ausgerichteten Z-Magnetfeldkomponente antisymmetrische und in der X/Y-Magnetfeldsensorebene liegende Magnetfeldkomponenten erzeugt.

Mit anderen Worten werden mindestens zwei Halbbrücken einer Wheatstone-Messbrücke vorgeschlagen, deren Brücken-Widerstände magnetoresistive Elemente umfassen, gegenüberliegend zu einer weichmagnetischen Flussführungseinheit angeordnet. Die Magnetisierungsrichtungen der magnetoresistiven Elemente und damit die Empfindlichkeitsrichtungen der Sensorelemente sind dabei annähernd parallel oder antiparallel einstellbar. Die gegenüberliegenden Halbbrücken sind zu einer sogenannten Wheatstone-Messbrücke verschaltbar.

Zur einfacheren Erläuterung der erfindungsgemäßen Lösung wird nachfolgend die in der Ebene liegende Komponente als X-Komponente und die senkrecht zur Sensoranordnung liegende Komponente als Z-Komponente benannt. Die Empfindlichkeitsrichtung eines Sensorelementes sei in X-Richtung angenommen.

Magnetfeldkomponenten eines Magnetfelds, die in der X/Y-Sensorebene liegen, bewirken durch den in X-Richtung liegenden Anteil in den magnetosensitiven Brückenwiderständen ein erstes Widerstandsverhalten in den beiden Halbbrücken, dass sich auf eine Differenzspannung ΔU=U1-U2 zwischen dem Mittelabgriff der Brücke bzw. auf eine Spannungsänderung U1, U2 der Mittelabgriffe gegenüber einem Referenzpotential U0 auswirkt. Eine Z-Magnetfeldkomponente bewirkt durch das Flusskonzentrationselement zwei antisymmetrische Feldkomponenten, die in der X/Y-Sensorebene liegen, und die ein zweites Widerstandsverhalten in den magnetosensitiven Brückenwiderständen hervorruft. Somit kann durch eine geeignete Auswerteelektronik bei bekanntem Widerstandsverhalten der Mittelabgriffsspannungen U1, U2 auf eine X-Magnetfeldkomponente eine Größe sowohl der X-Magnetfeldkomponente als auch der Z-Magnetfeldkomponente ermittelt werden. Denn werden die Magnetisierungsrichtungen so eingestellt, dass sich die Signalanteile beider Halbbrücken in der Vollbrücke addieren, so ist die Anordnung empfindlich auf die X-Komponente. Aufgrund der vorhandenen Flussführungseinheit wird eine evtl. vorhandene Z-Komponente in den Halbbrücken genau vorzeichenmäßig entgegengesetzte Anteile liefern, die dann aufgrund der Addition der Signalanteile in der Vollbrücke nichts zum Gesamtsignal beitragen.

Die erfindungsgemäße Anordnung erlaubt somit die Erfassung von zwei zueinander senkrecht stehenden Magnetfeldkomponenten dadurch, dass die Empfindlichkeitsrichtung in mindestens einer Halbbrücke umschaltbar ist.

Gemäß einer vorteilhaften Ausführungsform können die magnetfeldsensitiven Brückenwiderstände AMR-, GMR- oder TMR-Widerstände sein. Diese Widerstände weisen eine magnetfeldsensitive Vorzugsrichtung auf, in der diese Widerstände auf eine Veränderung der Magnetfeldkomponente mit einer Änderung des ohmschen Widerstands reagieren. AMR-Widerstände können in ihrem Widerstandskennlinienverhalten durch eine Beeinflussung einer inneren Vormagnetisierung beeinflusst werden, so dass die Widerstandskennlinie umschaltbar zur Auswertung der X- und Z-Komponente verändert werden kann.

Erfindungsgemäß ist die schaltungstechnische Anordnung zumindest der Brückenwiderstände einer Halbbrücke individuell umschaltbar. Dadurch ergibt sich bzgl. einer X-Komponente ein geändertes Widerstandsverhalten, so dass zwischen einem Effekt bei einer X- und Z-Magnetfeldkomponente unterschieden werden kann.

Alternativ oder zusätzlich weisen ein, bevorzugt alle magnetfeldsensitiven Brückenwiderstände eine umschaltbare Widerstandskennlinie auf. Durch Umschalten einer internen Magnetisierungsrichtung in mindestens einem magnetoresistiven Brückenelement und durch geeignete Signalauswertung mit diesen mindestens 2 Halbbrücken ist es nun möglich sowohl eine horizontale, also in der Sensorebene liegende Komponente als auch die zur Sensorebene senkrecht liegende Komponente des Magnetfeldes zu messen.

Wird die Magnetisierungsrichtung und in Folge somit die Empfindlichkeitsrichtung in einer Halbbrücke so eingestellt, das sich bei vorhandenen Magnetfeldanteilen in X-Richtung die jeweiligen Beiträge in der Vollbrücke durch die Differenzbildung gerade aufheben, so ist die Anordnung in diesem Zustand hinsichtlich Komponenten in X-Richtung unempfindlich. Ist im zu messenden Magnetfeld jedoch eine Z-Komponente vorhanden, so liefert diese in den Halbbrücken vorzeichenmäßig entgegengesetzte Beiträge. Durch die Differenzbildung in der Vollbrücke entsteht somit ein Messsignal für die Z-Komponente des zu messenden Magnetfeldes.

Gemäß einer vorteilhaften Ausführungsform kann zumindest ein Vormagnetisierungsumschalteinheit, insbesondere ein Flipleiter umfasst sein, der eine interne Magnetisierung zur Definition der Widerstandskennlinie zumindest eines magnetfeldsensitiven Brückenwiderstands flippen, d.h. ummagnetisieren kann. Mittels eines Flipleiters, insbesondere eines jedem magnetfeldsensitive Brückenwiderstand individuell zugeordneten Flipleiters, der z.B. spiral- oder mäanderförmig unterhalb oder oberhalb des magnetfeldsensitiven Brückenwiderstands geführt werden kann, kann ein Flipmagnetfeld erzeugt werden, durch das ein innerer Vormagnetisierungszustand des Brückenwiderstands verändert und somit das Widerstandskennlinienverhalten, dass in der Fig. 2 dargestellt ist, durch Vorgabe eines kurzfristigen Flipstromimpulses individuell für jeden der magnetfeldsensitiven Brückenwiderstände verändert werden kann.

Grundsätzlich genügt es, dass zwei der vier Brückenwiderstände magnetosensitiv ausgebildet sind. Dies können die unteren beiden, die oberen beiden oder diagonal zugeordnete Brückenwiderstände der beiden Halbbrücken der Widerstandsmessbrücke sein. Gemäß einer vorteilhaften Ausführungsform können alle Widerstände der Wheatstone-Messbrücke magnetfeldsensitive Widerstände sein. Somit wird eine verbesserte Empfindlichkeit der Magnetfeldsensorvorrichtung erreicht.

Gemäß einer vorteilhaften Ausführungsform können zwei Wheatstone-Messbrücken umfasst sein, wobei die Ausrichtung der in der X/Y-Magnetfeldsensorebene liegenden messsensitiven Magnetfeldkomponenten der beiden Messbrücken rechtwinklig gewählt wird. Die beiden Messbrücken sind in der X/Y-Ebene um 90° gegenüber versetzt, so dass eine Messbrücke für eine Magnetfeldkomponente in X-Richtung und eine weitere Messbrücke für eine Magnetfeldkomponente in Y-Richtung empfindlich ist. Eine Z-Komponente kann auf beide Messbrücken einen Einfluss haben, sofern beide Messbrücken symmetrisch um das Flusskonzentrationselement angeordnet sind. Somit lässt sich mittels beider Wheatstone-Messbrücke eine Z-Komponente ermitteln. Die beiden Werte der Z-Komponente kann vorteilhafterweise gemittelt werden, um eine höhere Genauigkeit bei der Ermittlung der Z-Komponente zu erreichen. Alternativ ist denkbar, dass die Halbbrücken einer einzelnen Messbrücke symmetrisch bezüglich des Flusskonzentrationselements angeordnet sind, so dass nur bezüglich einer der beiden Messbrücken eine Z-Magnetfeldkomponente messbar ist.

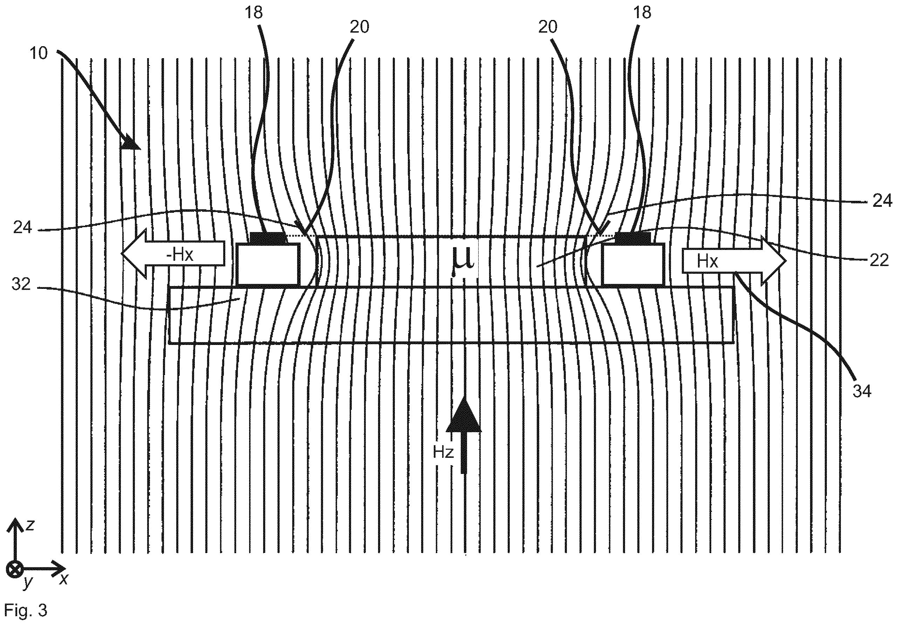

Die feldbeeinflussende Wirkung des Flusskonzentrationselements liegt ein einer überaus hohem magnetischen Permeabilität µ, wodurch die Z-Magnetfeldkomponente in das Flusskonzentrationselement förmlich hineingezogen d.h. konzentriert wird, so dass am Randbereich des vorteilhafterweise quaderförmig oder würfelförmiges Flusskonzentrationselements Inhomogenitäten der Z-Magnetflussdichte entstehen. Hierdurch wird, wie in Fig. 3 veranschaulicht, entlang des Randumfangs des vorteilhafterweise plattenförmigen Flusskonzentrationselements eine Auftreten von in der X/Y-Magnetfeldkomponente liegenden Magnetfeldkomponenten durch die Flussführungskonzentration der Z-Magnetfeldkomponente bewirkt, die entweder senkrecht zur Berandung des Flusskonzentrationselements hin- bzw. wegweisen. Gemäß einer vorteilhaften Ausführungsform kann das ferromagnetische Flusskonzentrationselement aus Eisen, Cobalt, Nickel, einer ferromagnetische Legierungen wie AlNiCo, SmCo, Nd2Fe14B, Ni80Fe20 (Permalloy), NiFeCo-Legierung oder einer Kombination hieraus bestehen. Ein ferromagnetisches Flusskonzentrationselement weist eine hohe magnetische Suszeptibilität und somit eine hohe Primitivität µ auf, sodass extrem große Z-Magnetfeldkomponenten-Flussdichteinhomogenitäten am Randbereich des Flusskonzentrationselementes bewirkt werden können.

Gemäß einer vorteilhaften Ausführungsform kann das ferromagnetische Flusskonzentrationselement eine symmetrische Form, insbesondere eine spiegel- oder rotationssymmetrische Form, insbesondere eine rechteckförmige, insbesondere eine quadratische Form in der X/Y-Magnetfeldsensorebene aufweisen, wobei die Seitenkanten des Flusskonzentrationselements in der X/Y-Richtung ausgerichtet sind. Durch eine symmetrische Form wird die Ausbildung antisymmetrischer X/Y-Magnetfeldkomponenten aufgrund der Z-Magnetfeldkomponente gefördert, so dass die Widerstandsveränderung in den Halbbrücken der Widerstandsmessbrücke aufgrund der Z-Magnetfeldkomponente symmetrisch erfolgt. Bevorzugt ist das Flusskonzentrationselement in Form eines Quaders oder eines Würfels ausgebildet. Bevorzugte Dimensionen des Flusskonzentrationselements können im Bereich 100-1000µm liegen.

Gemäß einer vorteilhaften Ausführungsform kann eine obere oder eine untere Oberfläche des Flusskonzentrationselement in der X/Y-Magnetfeldsensorebene liegen. Die X/Y-Magnetfeldsensorebene definiert eine parallel zur Chipsubstratoberfläche oder Platinensubstratoberfläche ausgerichtete Ebene, in der die magnetfeldsensitiven Widerstände angeordnet sind und in der eine maximale Sensitivität bezüglich einer darin liegenden Magnetfeldkomponente erreicht wird. Wie in Fig. 3 zu erkennen ist, wird der Verlauf einer Z-Magnetfeldkomponente im Bereich der oberen und unteren Oberfläche des Flusskonzentrationselements maximal abgelenkt, so dass in der unteren und oberen Oberflächenebene des Flusskonzentrationselements die größten X- und Y-Magnetfeldkomponenten aufgrund der Flusskonzentrationswirkung entstehen. Durch Anordnung der X/Y-Magnetfeldsensorebene in der Ebene der oberen oder unteren Oberfläche des Flusskonzentrationselementes kann die höchste Magnetfeldsensitivität bezüglich einer Änderung der Z-Magnetfeldkomponente erreicht werden.

In einem Nebenaspekt wird ein Verfahren zur Bestimmung von zwei oder drei Komponenten eines Magnetfelds durch eine oben beschriebene Magnetfeldsensorvorrichtung vorgeschlagen, wobei eine in einer X/Y-Sensorebene liegende Magnetfeldsensorkomponente in beiden Halbbrücken eine Spannungsveränderung U1, U2 am Mittelabgriff der Halbbrücke in einer ersten Größenänderung bewirkt, und eine in Z-Richtung senkrecht zur X/Y-Sensorebene eine abweichende Spannungsveränderung in einer zweiten Größenänderung bewirkt. So wirkt eine in der Sensorebene liegende Magnetfeldkomponente auf die magnetosensitiven Widerstände beider Halbbrücken gleichartig ein. Je nach den Widerstandskennlinienverläufe der Widerstände und deren Zuordnung in den Halbbrücken verändern sich die Halbbrücken-Mittelabgriffsspannungen U1, U2 derart, so dass eine Differenzspannung ΔU erhöht oder minimiert wird. Eine Z-Magnetfeldkomponente bewirkt antisymmetrische Magnetfeldkomponenten in der Sensorebene, die gegensinnig auf die magnetosensitiven Widerstände wirkt. Dies bewirkt ein gegenläufiges Verhalten der Mittelabgriffsspannungen U1, U2. Der Einfluss einer Z-Magnetfeldkomponente ist somit gegenläufig auf das Widerstandsverhalten der Messbrücke zu einem Einfluss einer in der Sensorebene liegenden externen Magnetfeldkomponente. Eine Auswerteelektronik erkennt diese gegenläufigen Widerstandsänderungen und kann unter Kenntnis auf das spezifische Widerstandsverhalten sowohl auf die Größe der Z-Komponente als auch auf die Größe der X- bzw. X- und Y-Komponente schließen. Somit kann mit einer einzelnen Messbrücke zwei senkrecht aufeinander stehende Magnetfeldkomponenten erfasst werden, wobei eine Komponente in der Sensorebene und eine Magnetfeldkomponente senkrecht hierzu steht.

Erfindungsgemäß erfolgt ein Umschalten zumindest eines, insbesondere ein paarweises Umschalten der Widerstandskennlinien einander zugeordneter magnetfeldsensitiver Widerstände der beiden Halbbrücken oder eine Umschaltung der schaltungstechnischen Anordnung der Brückenwiderstände in zumindest einer Halbbrückeoder eine Umschaltung der Versorgungsspannung in zumindest einer Halbbrücke, wobei in einem ersten Zustand M1, M3 eine in der X/Y-liegende Magnetfeldkomponente durch gegensinnige Widerstandskennlinienverläufe einander korrespondierender magnetfeldsensitiver Brückenwiderstände messbar und in einem zweiten Zustand M2, M4 eine in Z-Richtung liegende Magnetfeldkomponente durch gleichsinnige Widerstandskennlinienverläufe einander korrespondierender magnetfeldsensitiver Brückenwiderstände messbar ist. Ein Zustand M1 kann definiert werden als gegensinnige Widerstandskennlinien zweier zueinander zugeordneter magnetfeldsensitiven Widerstände der beiden Halbbrücken einer Widerstandsmessbrücke Dies bewirkt, dass beispielsweise bei Auftreten einer X-Magnetfeldkomponente der Widerstand in eines ersten magnetfeldsensitiven Widertands der ersten Halbbrücke steigt und der Widerstand eines zweiten magnetfeldsensitiven Widerstands der zweiten Halbbrücke sinkt. Sind beide Widerstände als untere Widerstände der Halbbrücke angeordnet, erhöht sich die Differenzspannung ΔU=U1-U2. Eine Z-Magnetfeldkomponente bewirkt antisymmetrische X-Magnetfeldkomponenten, die Differenzspannung ΔU sinkt hierdurch gegen Null ab. Ein Zustand M3 kann genauso definiert werden, wobei der erste und der zweite Widerstand gegenüber dem Zustand M1 ein gegenläufiges Verhalten der Widerstandskennlinie aufweist. Im Zustand M1 würde eine in positiver X-Richtung ausgerichtete Komponente eine positive Differenzspannung ΔU>0 und im Zustand M3 eine negative Differenzspannung ΔU<0 zur Folge haben. Eine Z-Komponente minimiert die Differenzspannung ΔU≈0. Die Zustände M2 bzw. M4 bedeuten ein gleichläufiges Verhalten der Widerstandskennlinien des unteren Widerstands der ersten Halbbrücke und unteren Widerstands der zweiten Halbbrücke. Demzufolge bewirkt eine X-Magnetfeldkomponente eine Minimierung der Differenzspannung ΔU≈0 und eine Z-Magnetfeldkomponente bewirkt eine positive Differenzspannung ΔU>0 (Zustand M2) bzw. eine negative Differenzspannung ΔU<0.

Nach einem bevorzugten Verfahren kann ein Umschalten der Zustände in der Reihenfolge M1, M2, M1, und M2 oder M1, M2, M3 und M4 erfolgen. Durch ein sequentielles Umschalten, beispielsweise in den vorgegebenen Zustandsreihenfolgen kann die Größe der X- und Z-Magnetfeldkomponente isoliert für sich betrachtet werden, wobei im Zustand M1, M3 die Differenzspannung Auskunft über die Größe und Vorzeichen der X-Komponente und im Zustand M2, M4 Auskunft über die Größe und Vorzeichen der Z-Komponente erlangt werden kann.

Vorteilhafterweise kann ein Spannungsoffset der Messbrücke durch eine Auswerteeinheit ausgefiltert werden. Die Auswerteeinheit kann die vorgegebenen Zustände M1-M4 beispielsweise durch Abgabe eines Flipstromimpulses oder eines Umschalten der schaltungstechnischen Verbindung zwischen den Brückenwiderständen oder der Polarität der Halbbrückenspannung einstellen und anschließend eine Differenzspannung ΔU oder Halbbrückenspannungen U1, U2 aufnehmen. Eine Frequenz der Umschaltung der Zustände kann abhängig von der Anwendung im Bereich weniger Herz bis in dem kHz-Bereich erfolgen. Ein Offset zwischen den beiden Halbbrückenspannungen, der fertigungstechnisch durch Inhomogenitäten der Widerstände bewirkt wird, und der im Magnetfeldfreien Zustand bestimmbar ist, kann durch die Auswerteeinheit berücksichtig und ausgefiltert werden, um eine hohe Genauigkeit der Magnetfeldmessung zu erreichen.

Weitere denkbare Parameter zur Definition der Magnetfeldsensorvorrichtung sind die Maße der Chips und des Flussführungselements, der Abstand des Chips bzw. der Halbbrückenwiderstände zum Flussführungselement, Details zum sequenziellen Umschalten der Magnetisierung um auch Offsets zu ermitteln und zu eliminieren. Das Flussführungselement kann als diskretes Bauelement ausgebildet sein, und kann prozesstechnisch mittels Dickschichttechniken, galvanisch, durch eine Drucktechnik auf ein Chipsubstrat oder Platinensubstrat aufgebracht werden.

### ZEICHNUNGEN

Weitere Vorteile ergeben sich aus der vorliegenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- **Fig. 1, Fig. 2:**: Widerstandsstreifen mit Barberpolestruktur nach dem Stand der Technik;
- **Fig. 3**: Schnitt durch eine Z-X-Ebene einer Chipanordnung eines ersten Ausführungsbeispiels mit Flusskonzentrationselement;
- **Figs. 4 - 7**:: Ein weiteres Ausführungsbeispiel eines 2D- Magnetfeldsensors mit 2 Halbbrücken, wobei jede Halbbrücke nur einen magnetoresistiven Widerstand aufweist. Hierzu werden vier verschiedene innere Magnetisierungsrichtungen vorgegeben und eine Sensitivität des jeweiligen Halbbrückenspannungen bei externem Magnetfeld in X- und Z-Richtung angegeben;
- **Figs. 8 - 11**:: Ein weiteres Ausführungsbeispiel eines 2D- Magnetfeldsensors mit 2 Halbbrücken, wobei jede Halbbrücke zwei magnetoresistive Widerstände aufweist. Hierzu werden vier verschiedene innere Magnetisierungsrichtungen vorgegeben und eine Sensitivität des jeweiligen Halbbrückenspannungen bei externem Magnetfeld in X- und Z-Richtung angegeben;
- **Fig. 12:**: Ein weiteres Ausführungsbeispiel eines 3D-Magnetfeldsensors zur Messung aller drei Komponenten eines externen Magnetfeldes;
- **Figur 13:**: Ein Ausführungsbeispiel zur schaltungstechnischen Umschaltung verschiedener Empfindlichkeitsrichtungen einer erfindungsgemäßen Magnetfeldsensorvorrichtung.

In den Figuren sind gleichartige Elemente mit gleichartigen Bezugszeichen beziffert.

In der Fig. 1 ist eine Widerstandskennlinie in Abhängigkeit eines Magnetfelds *M*(*H*) gegenüber der Richtung eines Messstromflusses *I*_{S} durch einen AMR-Widerstandsstreifen 102 einer Magnetfeldsensorvorrichtung 100 dargestellt. Die Widerstandskennlinie *R*(*M*) bestimmt sich durch die Formel **Fehler! Es ist nicht möglich, durch die Bearbeitung von Feldfunktionen Objekte zu erstellen.,** wobei θ der Winkel zwischen Stromflussrichtung *I*_{S} und einem Gesamtmagnetfeld *M*(*H*) darstellt. Das Gesamtmagnetfeld *M*(*H*) setzt sich aus einem Magnetfeld einer inneren Vormagnetisierung *M*₀ und einem externen, zu messenden Magnetfeld *H*e zusammen. Man erkennt, dass bei kleinen Magnetfeldern *H*ₑ *< M*₀ nur eine geringe Änderung des Widerstands *R* bei Änderung des externen Magnetfelds *H*ₑ auftritt. Somit ist eine derartige Konfiguration nachteilig, da die Sensitivität für kleine Magnetfelder relativ gering ist, da die Widerstandskennlinie in diesem Bereich nur eine geringe Steigung aufweist.

In der Fig. 2, die eine AMR-Widerstandsvorrichtung 100 nach dem Stand der Technik darstellt, bei dem ein AMR-Widerstandsstreifen 102 mit um 45° geneigten Barberpolstrukturen 104, d.h. hochleitenden Metallisierungsstreifen wie Gold- oder Kupfermetallisierungen, auf dem AMR-Widerstandsstreifen 102 angeordnet sind, versehen ist. Wie in der Schemaskizze dargestellt, wird durch die AMR-Widerstandsstreifen 104 ein Stromfluss *I*_{S} durch den AMR-Widerstandsstreifen 102 in einer im Wesentlichen 45°-Richtung zur Längsausdehnung des Widerstandsstreifen 102 ausgebildet, so dass der Stromfluss gegenüber einer parallelen inneren Magnetisierung *M*₀ bzw. einem rechtwinkligen externen Magnetfeld *H*ₑ einen Linearisierungswinkel α von 45° annimmt. Dementsprechend wird die in Fig. 1 dargestellte Widerstandskurve verschoben, und zwar in einem Bereich einer steilen Flanke des Kurvenverlaufs, bei dem eine lineare Abhängigkeit von Widerstand zu Magnetfeld auftritt, so dass eine geringe Änderung eines externen Magnetfelds *H*ₑ eine lineare Änderung des Gesamtwiderstands *R* des Widerstands der AMR-Magnetfeldsensorvorrichtung hervorruft. Mittels einer Linearisierung durch Barberpolstrukturen lässt sich die Sensitivität der Magnetfeldsensorvorrichtung deutlich erhöhen.

Die Darstellung der Fig. 3 lehnt sich an eine Darstellung aus der DE 10 2008 041 859 A1 an und stellt ein erstes Ausführungsbeispiel einer erfindungsgemäßen Magnetfeldsensorvorrichtung 10 dar. Die in Fig. 3 schematisch dargestellte Magnetfeldsensorvorrichtung 10 besteht aus einem weichmagnetischen Flusskonzentrationselement 22, das sich auf der Oberfläche eines Substrats 32, hier eines Halbleiterchips als Träger zum Beispiel von AMR-Sensoren als magnetfeldsensitiven Brückenwiderständen 18, befindet. Aus der Fig. 3 ist zu entnehmen, dass zum Beispiel Feldlinien eines zu erfassenden Magnetfeldes Hz 24, dass in Z-Richtung ausgerichtet ist, am Randbereich des Flusskonzentrationselements 22 aus ihrer ursprünglich vertikalen Z-Richtung in eine horizontale X-Richtung ausgelenkt werden, so dass diese für die magnetfeldsensitiven Brückenwiderstände 18 messbar werden. Es bilden sich antisymmetrische Hx-Komponenten 34 aus, die auf die benachbart zum Randbereich des Elements 22 angeordneten Widerstände 22 gegensinnig einwirken. Da die Strecken der Feldlinien 24 im Material des Flusskonzentrationselements 22 für die Ablenkung vertikal zu horizontal kürzer sind als die Strecke für die Ablenkung horizontal zu vertikal, ergibt sich zwar ein geringer Ablenkungseffekt, d.h. im Verhältnis zur Hz-Feldstärke deutlich geringere Hx-Komponenten, die durch eine hohe Empfindlichkeit der Brückenwiderstände 30 bestimmt werden können. Um den Messeffekt zu erhöhen, kann das Flusskonzentrationselement 22 in einer hier nicht gezeigten Weise in die Substratschicht 32 des Halbleiterchips eingesenkt werden. Die X/Y-Magnetfeldsensorebene, d.h. die parallele Ebene zum Chipsubstrat 32, in der Hx-Komponenten die größten Widerstandsänderungen in den Brückenwiderständen 18 bewirken, liegt auf der Höhe der Oberfläche des quaderförmigen Flusskonzentrationselementes 22. Beim Eintritt der Hz-Komponente in das Flusskonzentrationselement 22 weist - wie in Fig. 3 dargestellt - der Feldstärkenverlauf der Hz-Komponente die betragsstärksten Hx-Komponentenanteile auf, die entsprechend hochsensitiv durch die Brückenwiderstände 18 erfasst werden können.

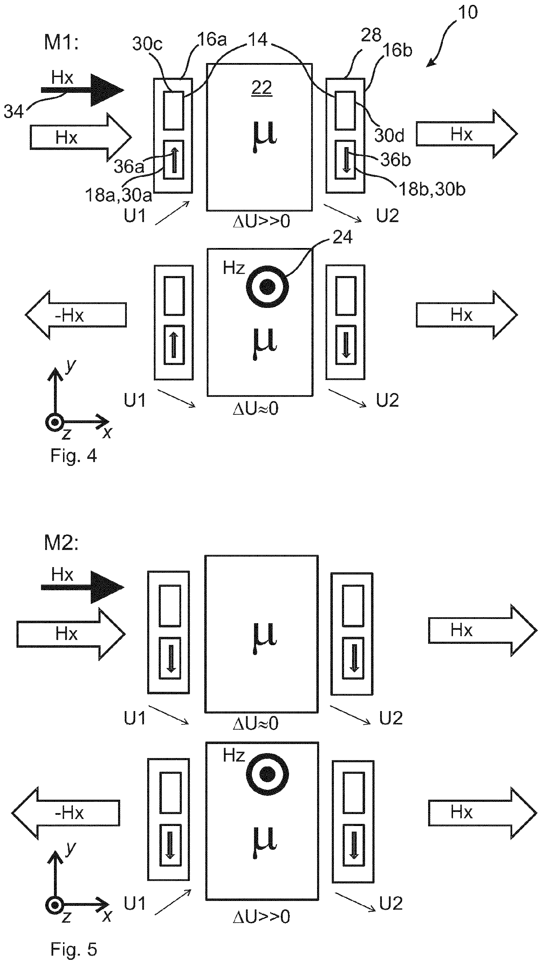

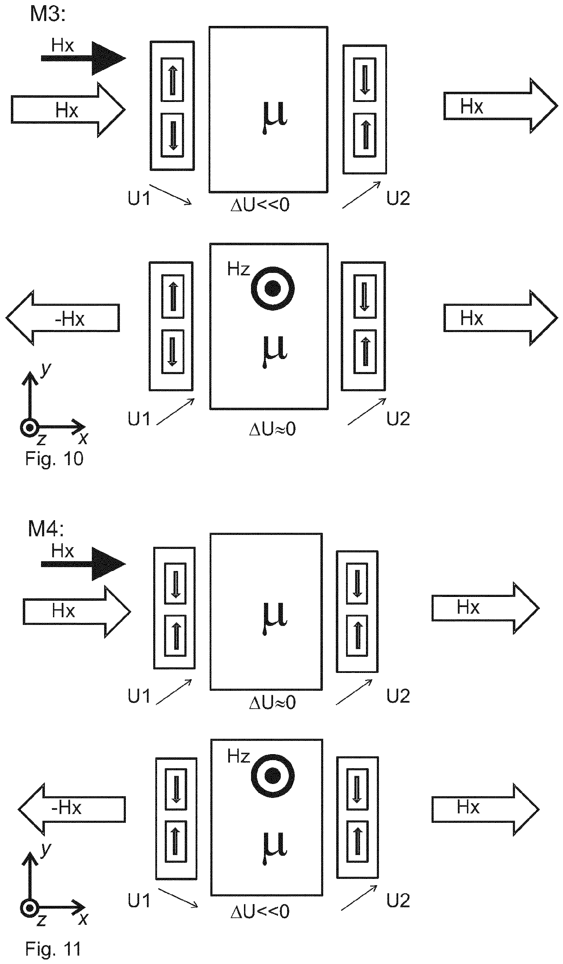

In den Figuren 4 bis 11 sind zwei weitere Ausführungsbeispiele von erfindungsgemäßen Magnetfeldsensorvorrichtungen 10 dargestellt, bei denen AMR-Magnetfeldwiderstände 18 mit Barberpolstrukturen eingesetzt werden, deren Widerstandskennlinien durch eine Veränderung einer internen Vormagnetisierung umgeschaltet werden können, wie dies in der Fig. 2 dargestellt ist. Lediglich in einem oberen Teilbild der Fig. 4 sind Bezugszeichen angebracht, die sinngemäß auf alle weiteren Figuren 5 bis 11 übertragen werden können, und aus Gründen der Übersichtlichkeit dort weggelassen sind.

In den Figuren 4 bis 7 ist eine 2D-Magnetfeldsensorvorrichtung 10 dargestellt, die zwei Halbbrücken 16a, 16b einer Wheatstone-Messbrücke 14 umfasst. Zwischen den beiden Halbbrücken 16a, 16b ist ein quaderförmiges Flusskonzentrationselement 22 aus hochpermeablem Material wie z.B. Permalloy angeordnet. Jede Halbbrücke 16a, 16b umfasst ein Paar von zwei Brückenwiderständen 30a-30c bzw. 30b-30d. Die zueinander zugeordneten unteren Brückenwiderstände 30a, 30b der beiden Halbbrücken 16a, 16b sind als magnetfeldsensitive Brückenwiderstände 18a, 18b ausgebildet. Die weiteren zugeordneten Brückenwiderstände 30c, 30d sind ohmsche Widerstände, die keine Magnetfeldbeeinflussung aufweisen. Jeder der beiden magnetfeldsensitiven Widerstände 18a, 18b weist eine Widerstandskennlinie 36a, bzw. 36 auf, die durch die dargestellten schwarzen Pfeile angedeutet sind, und die den in der Fig. 2 dargestellten Widerstandskennlinien 36a, 36b entsprechen.

In der Fig. 4 wird ein erster Zustand M1 dargestellt, bei dem Widerstand 18a einen in Fig. 2 links dargestellte Widerstandskennlinie 36a und Widerstand 18b ein in Fig. 2 rechts dargestellte Widerstandskennlinie 36b bezüglich einer Hx-Komponente 34 aufweisen. Im oberen Teilbild der Fig. 4 ist erkennbar, dass bei einer Erhöhung der Hx-Komponente 34 die Spannung U1 der ersten Halbbrücke 16a steigt, während die Spannung U2 der zweiten Halbbrücke 16b sinkt, so dass die Differenzspannung ΔU vergrößert wird. Im unteren Teilbild der Fig. 4 ist das Verhalten bezüglich einer Z-Magnetfeldkomponente 24 Hz dargestellt. Die Hz-Komponente 24 bewirkt bezüglich der ersten Halbbrücke 16a eine Hx-Komponente in negativer X-Richtung und bezüglich der zweiten Halbbrücke 16b eine antisymmetrische Hx-Komponente in positiver X-Richtung. Demzufolge sinken bei dem vorgegebenen Zustand M1 die beiden Halbbrückenspannungen U1, U2 ab, so dass die Differenzspannung ΔU gegen Null geht.

In der Fig. 5 wird bezüglich eines zweiten Zustand M2, in dem beide Widerstände 18a, 18b einen rechten Widerstandskennlinien 36b der Fig. 2 folgen, ein Verhalten der Magnetfeldsensorvorrichtung auf eine Hx- und und Hz-Komponente dargestellt. In diesem Fall bewirkt eine Hx-Komponente 34 einen Differenzspannung ΔU, der gegen Null geht, und eine Hz-Komponente 24 bewirkt eine positiv steigende Differenzspannung ΔU.

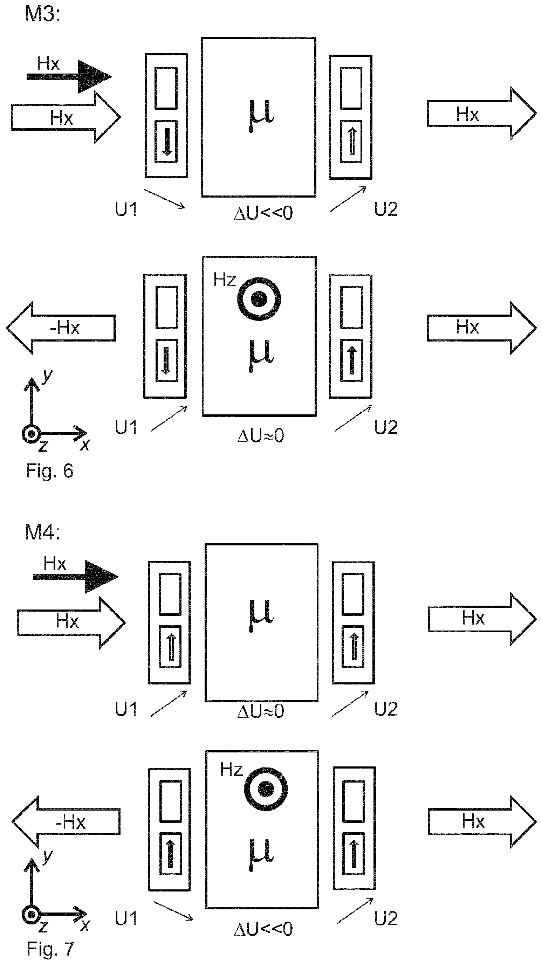

In der Fig. 6 ist ein Zustand M3 dargestellt, der dem Zustand M1 der Fig. 4 entspricht, allerdings weisen die beiden Widerstände 18a, 18b nun antisymmetrische Widerstandskennlinien 36b bzw. 36a auf. Gleiches gilt für Fig. 7 mit Zustand M4 in Bezug auf den Zustand M2 der Fig. 5.

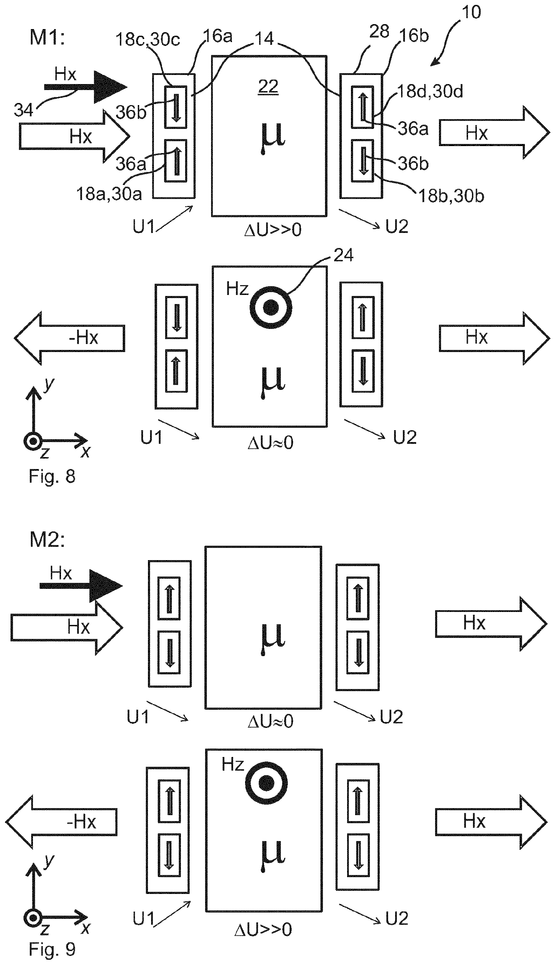

In den Figuren 8 bis 11 sind weitere Ausführungsbeispiele einer 2D-Magnetfeldsensorvorrichtung 10 dargestellt, wobei alle Brückenwiderstände 30 magnetfeldsensitive Widerstände 18 sind. Die Fig. 8 stellt entsprechend der Figur 4 einen ersten Zustand M1 der vier eingezeichneten Brückenwiderstände 18a bis 18d dar. Die Figs. 9 bis 11 stellen weitere Zustände M2 bis M4 entsprechend den Figuren 5 bis 7 dar. Die Zustände M1 und M3 entsprechen sich, wobei die Kennlinienverläufe 36a, 36b der Widerstände 18a bis 18d paarweise antisymmetrisch sind. Gleiches gilt für die Zustände M2 und M4 mit symmetrischen Widerstandskennlinien 36a, 36b der in den Halbbrücken 16a, 16b jeweils zugeordneten unteren und oberen Widerständen 18a-18b bzw. 18c-18d. Ein oberes Teilbild gibt ein Spannungsverhalten U1, U2 bezüglich einer Hx-Komponente 34 und ein unteres Teilbild ein Spannungsverhalten U1, U2 bezüglich einer Hz.Komponente 24 an.

Die Zustände M1, M3 können zur Bestimmung von Richtung und Stärke der Hx-Komponente 34 und die Zustände M2, M4 zur Bestimmung von Richtung und Stärke der Hz-Komponente 24 verwendet werden.

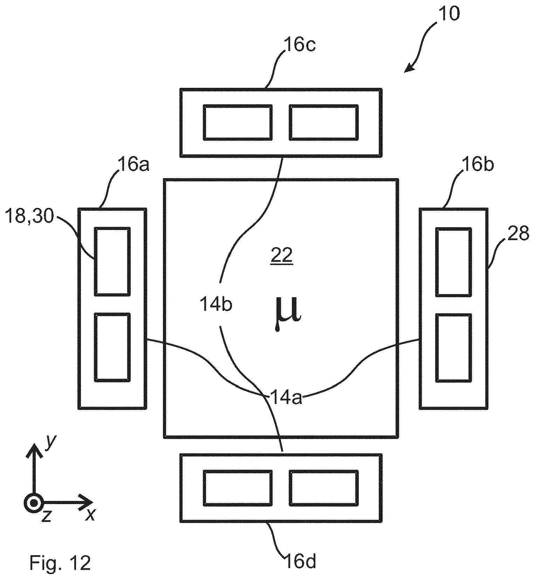

Fig. 12 zeigt ein weiteres Ausführungsbeispiel einer Magnetfeldsensorvorrichtung 10 zur Bestimmung eines dreidimensionalen Magnetfeldverlaufs mittels zweier Wheatstone-Messbrücken 14a, 14b. Im Fall einer 3D-Sensorvorrichtung 10 weist das Flusskonzentrationselement 22 eine im Wesentlichen quadratische Form auf, wobei durch die Definition von mehreren Zuständen sowohl eine Hx-, eine Hy- und eine Hz-Komponente mittels zweier Differenzspannungen ΔUa und ΔUb ermittelbar ist. Die Größe der Hz-Komponente kann sowohl von Messbrücke 14a als auch von Messbrücke 14 erfasst werden. Durch eine Mittelung der beiden ermittelten Hz-Messwerte kann eine erhöhte Genauigkeit erreicht werden.

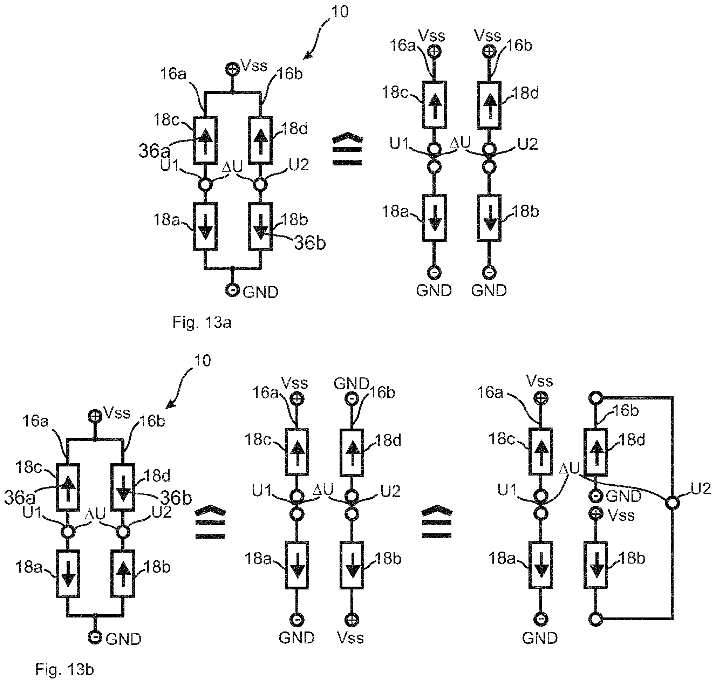

Schließlich zeigt Fig. 13a und Fig. 13b. elektrische Ersatzschaltbilder eines weiteren Ausführungsbeispiels einer Magnetfeldsensorvorrichtung 10. So stellt Fig. 13a im linken Teilbild eine Brückenschaltung dar, die der Konfiguration der Fig. 9 als Zustand M2 entspricht. Die Anordnung ist für eine Messung von Komponenten in der Z-Achse empfindlich. Sind alle Anschlusskontakte der Brückenwiderstände 18a bis 18d unabhängig voneinander kontaktierbar, so zeigt das rechte Teilbild der Fig. 13a die Kontaktierung der einzelnen Brückenwiderstände 18a bis 18d mit der Versorgungsspannung Vss, dem Ground-Potential GMD bzw. den Mittelabgriffsspannungen U1, U2 sowie der resultierenden Differenzspannung ΔU=U1-U2.

In der Fig. 13b werden drei Konfigurationen ausgehend von Fig. 13a dargestellt, die im Vergleich zu Fig. 13a eine Empfindlichkeitsrichtung in X-Richtung aufweisen. Neben der Umschaltung der Magnetisierungsrichtung der Elemente 18d und 18b (linkes Teilbild) erreicht man ein Umschalten der Empfindlichkeitsrichtung dadurch, dass die Versorgungsspannung der rechten Halbbrücke 16b umgeschaltet wird (mittleres Teilbild), oder dadurch, dass die schaltungstechnische Anordnung der Widerstände 18b und 18d in der rechten Halbbrücke 16b im Vergleich zur Fig. 13a vertauscht wird

Die Erfindung vereinbart die Umlenkung einer senkrechten Magnetfeldkomponente mit Hilfe eines ferromagnetischen Flusskonzentrationselement in antisymmetrische Magnetfeldkomponenten in der Sensorebene mit den Vorteilen zur Umschaltung der Empfindlichkeitsrichtung und/oder des Flipprinzips, wobei durch eine geeignete Auswerteelektronik ein Messoffset eliminiert werden kann.

## Patentansprüche

1. Magnetfeldsensorvorrichtung (10) zur Bestimmung von zwei oder drei Komponenten eines Magnetfeldes, umfassend zumindest eine Wheatstonebrücke (14) mit zwei Halbbrücken (16), wobei jede Halbbrücke (16) zumindest zwei Brückenwiderstände (30) umfasst und zumindest einer der beiden Brückenwiderstände (30) ein magnetfeldsensitiver Widerstand (18) bezüglich einer in einer X/Y-Magnetfeldsensorebene (20) liegenden Magnetfeldkomponente (34) ist, wobei symmetrisch zwischen den beiden magnetfeldsensitiven Brückenwiderständen (18) ein ferromagnetisches Flusskonzentrationselement (22) angeordnet ist, das bezüglich einer senkrecht zur X/Y-Magnetfeldsensorebene (20) ausgerichteten Z-Magnetfeldkomponente (24) antisymmetrische und in der X/Y-Magnetfeldsensorebene (20) liegende Magnetfeldkomponenten erzeugt, **dadurch gekennzeichnet, dass** die schaltungstechnische Anordnung der Brückenwiderstände (18, 30) oder die Versorgungsspannung zumindest einer Halbbrücke (16) individuell umschaltbar ist und/oder zumindest ein, bevorzugt alle magnetfeldsensitiven Brückenwiderstände (18) eine umschaltbare Widerstandskennlinie (36) aufweisen, so dass ein Umschalten zumindest einer Widerstandskennlinie, insbesondere ein paarweises Umschalten der Widerstandskennlinien einander zugeordneter magnetfeldsensitiver Widerstände (18) der beiden Halbbrücken (16) oder eine Umschaltung der schaltungstechnischen Anordnung der Brückenwiderstände (18, 30) in zumindest einer Halbbrücke (16) durchführbar ist, wobei in einem ersten Zustand M1, M3 eine in der X/Y-liegende Magnetfeldkomponente (34) messbar ist und in einem zweiten Zustand M2, M4 eine in Z-Richtung liegende Magnetfeldkomponente (24) messbar ist.

2. Magnetfeldsensorvorrichtung (10) nach Anspruch 1, **dadurch gekennzeichnet, dass** die magnetfeldsensitiven Brückenwiderstände (18) AMR-, GMR- oder TMR-Widerstände sind.

3. Magnetfeldsensorvorrichtung (10) nach einem der vorhergehenden Ansprüche, **dadurch gekennzeichnet, dass** zumindest eine Vormagnetisierungsumschalteinheit, insbesondere ein Flipleiter umfasst ist, der eine interne Magnetisierung zur Definition der Widerstandskennlinie (36) zumindest eines magnetfeldsensitiven Brückenwiderstands (18) flippen, d.h. ummagnetisieren kann.

4. Magnetfeldsensorvorrichtung (10) nach einem der vorgenannten Ansprüche, **dadurch gekennzeichnet, dass** alle Widerstände (30) der Wheatstone-Messbrücke (14) magnetfeldsensitive Widerstände (18) sind.

5. Magnetfeldsensorvorrichtung (10) nach einem der vorgenannten Ansprüche, **dadurch gekennzeichnet, dass** zwei Wheatstone-Messbrücken (14a, 14b) umfasst sind, wobei die Ausrichtung der in der X/Y-Magnetfeldsensorebene (20) liegenden messsensitiven Magnetfeldkomponenten (34) der beiden Messbrücken (14a, 14b) rechtwinklig ist.

6. Magnetfeldsensorvorrichtung (10) nach einem der vorgenannten Ansprüche, **dadurch gekennzeichnet, dass** das ferromagnetische Flusskonzentrationselement (22) aus Eisen, Cobalt, Nickel, einer ferromagnetische Legierungen wie AlNiCo, SmCo, Nd2Fe14B, Ni80Fe20, NiFeCo-Legierung oder einer Kombination hieraus besteht.

7. Magnetfeldsensorvorrichtung (10) nach einem der vorgenannten Ansprüche, **dadurch gekennzeichnet, dass** das ferromagnetische Flusskonzentrationselement (22) eine symmetrische Form, insbesondere eine spiegel- oder rotationssymmetrische Form, insbesondere eine rechteckförmige, insbesondere eine quadratische Form in der X/Y-Magnetfeldsensorebene (20) aufweist, bei der bevorzugt die Seitenkanten des Flusskonzentrationselements (22) in der X/Y-Richtung ausgerichtet sind.

8. Magnetfeldsensorvorrichtung (10) nach einem der vorgenannten Ansprüche, **dadurch gekennzeichnet, dass** eine obere oder eine untere Oberfläche des Flusskonzentrationselement (22) in der X/Y-Magnetfeldsensorebene (20) liegt.

9. Verfahren zur Bestimmung von zwei oder drei Komponenten eines Magnetfeld durch eine Magnetfeldsensorvorrichtung (10) nach einem der vorgenannten Ansprüche, **dadurch gekennzeichnet, dass** ein Umschalten zumindest einer Widerstandskennlinie, insbesondere ein paarweises Umschalten der Widerstandskennlinien einander zugeordneter magnetfeldsensitiver Widerstände (18) der beiden Halbbrücken (16) oder eine Umschaltung der schaltungstechnischen Anordnung der Brückenwiderstände (18, 30) in zumindest einer Halbbrücke (16) erfolgt, wobei in einem ersten Zustand M1, M3 eine in der X/Y-liegende Magnetfeldkomponente (34) durch gegensinnige Widerstandsverläufe einander korrespondierender magnetfeldsensitiver Brückenwiderstände (18) messbar und in einem zweiten Zustand M2, M4 eine in Z-Richtung liegende Magnetfeldkomponente (24) durch gleichsinnige Widerstandsverläufe einander korrespondierender magnetfeldsensitiver Brückenwiderstände (18) messbar ist, so dass eine in einer X/Y-Sensorebene liegende Magnetfeldsensorkomponente (34) in beiden Halbbrücken (16) eine Spannungsveränderung U1, U2 am Mittelabgriff der Halbbrücke (16) in einer ersten Größenänderung bewirkt, und eine in Z-Richtung senkrecht zur X/Y-Sensorebene eine abweichende Spannungsveränderung in einer zweiten Größenänderung bewirkt.

10. Verfahren nach Anspruch 9, **dadurch gekennzeichnet, dass** ein Umschalten der Zustände in der Reihenfolge M1, M2, M1, und M2 oder M1, M2, M3 und M4 erfolgt.

11. Verfahren nach Anspruch 9 oder 10, **dadurch gekennzeichnet, dass** ein Spannungsoffset der Messbrücke (14) durch eine Auswerteeinheit ausgefiltert wird.

## Claims

1. Magnetic field sensing device (10) for determining two or three components of a magnetic field, comprising at least one Wheatstone bridge (14) with two half bridges (16), where each half bridge (16) comprises at least two bridge resistors (30) and at least one of said two bridge resistors (30) is a magnetic field-sensitive resistor (18) relative to a magnetic field component (34) in an X/Y magnetic field sensor plane (20), where a ferromagnetic flux concentration element (22) is arranged symmetrically between said two magnetic field-sensitive bridge resistors (18) and generates, relative to a Z magnetic field component (24) aligned perpendicularly to said X/Y magnetic field sensor plane (20), antisymmetrical magnetic field components in said X/Y magnetic field sensor plane (20), **characterized in that** the wiring arrangement of said bridge resistors (18, 30) or the supply voltage of at least one half bridge (16) is individually switchable and/or at least one and preferably all magnetic field-sensitive bridge resistors (18) have a switchable resistance characteristic (36), such that switching of at least one resistance characteristic, in particular paired switching of the resistance characteristics of magnetic field-sensitive resistors (18) associated with each other of said two half bridges (16) or switching of the wiring arrangement of said bridge resistors (18, 30) is performable in at least one half bridge (16), where a magnetic field component (34) in said X/Y sensor plane (20) is measurable in a first state M1, M3 and a magnetic field component (24) in the Z direction is measurable in a second state M2, M4.

2. Magnetic field sensing device (10) according to claim 1, **characterized in that** the magnetic field-sensitive bridge resistors (18) are AMR, GMR or TMR resistors.

3. Magnetic field sensing device (10) according to one of the preceding claims, **characterized in that** at least one premagnetization switching unit, in particular a flip conductor, is comprised that can flip, i.e. remagnetize, an internal magnetization for definition of the resistance characteristic (36) of at least one magnetic field-sensitive bridge resistor (18).

4. Magnetic field sensing device (10) according to one of the above claims, **characterized in that** all resistors (30) of the Wheatstone measuring bridge (14) are magnetic field-sensitive resistors (18).

5. Magnetic field sensing device (10) according to one of the above claims, **characterized in that** two Wheatstone measuring bridges (14a, 14b) are comprised, where the alignment of the measurement-sensitive magnetic field components (34) of said two measuring bridges (14a, 14b) in the X/Y magnetic field sensor plane (20) is right-angled.

6. Magnetic field sensing device (10) according to one of the above claims, **characterized in that** the ferromagnetic flux concentration element (22) consists of iron, cobalt, nickel, a ferromagnetic alloy such as AlNiCo, SmCo, Nd2Fe14B, Ni80Fe20, NiFeCo-alloy or a combination thereof.

7. Magnetic field sensing device (10) according to one of the above claims, **characterized in that** the ferromagnetic flux concentration element (22) has a symmetrical form, in particular a mirror-symmetrical or rotation-symmetrical form, in particular a rectangular, in particular a square form in the X/Y magnetic field sensor plane (20), in which the lateral edges of said flux concentration element (22) are preferably aligned in the X/Y direction.

8. Magnetic field sensing device (10) according to one of the above claims, **characterized in that** an upper or a lower surface of the flux concentration element (22) is in the X/Y magnetic field sensor plane (20).

9. Method for determining two or three components of a magnetic field by a magnetic field sensing device (10) according to one of the above claims, **characterized in that** switching of at least one resistance characteristic, in particular paired switching of the resistance characteristics of magnetic field-sensitive resistors (18) associated with each other of the two half bridges (16) or switching of the wiring arrangement of the bridge resistors (18, 30) takes place in at least one half bridge (16), where a magnetic field component (34) in the X/Y direction is measurable by opposite-direction resistance curves of corresponding magnetic field-sensitive bridge resistors (18) in a first state M1, M3, and a magnetic field component (24) in the Z direction is measurable by same-direction resistance curves of corresponding magnetic field-sensitive bridge resistors (18) in a second state M2, M4, such that a magnetic field component (34) in an X/Y sensor plane in both half bridges (16) effects a voltage change U1, U2 at the centre tap of said half bridge (16) in a first size change, and a magnetic field component (24) in the Z direction perpendicular to the X/Y sensor plane effects a differing voltage change in a second size change.

10. Method according to claim 9, **characterized in that** switching of the states is in the sequence M1, M2, M1, and M2 or M1, M2, M3 and M4.

11. Method according to claim 9 or 10, **characterized in that** a voltage offset of the measuring bridge (14) is filtered out by an evaluation unit.

## Revendications

1. Dispositif capteur de champ magnétique (10) servant à déterminer deux ou trois composantes d'un champ magnétique, comprenant au moins un pont de Wheatstone (14) comportant deux demi-ponts (16), sachant que chaque demi-pont (16) comprend au mois deux résistances de pont (30) et qu'au moins une desdites deux résistances de pont (30) est une résistance sensible au champ magnétique (18) par rapport à une composante de champ magnétique (34) située dans un plan X/Y (20) du capteur de champ magnétique, sachant qu'un élément ferromagnétique de concentration de flux (22) est disposé symétriquement entre les deux résistances de pont (18) sensibles au champ magnétique et génère des composantes de champ magnétique antisymétriques par rapport à une composante de champ magnétique Z (24) perpendiculaire au plan X/Y (20) du capteur de champ magnétique et situées dans le plan X/Y (20) du capteur de champ magnétique, **caractérisé en ce que** la disposition des résistances de pont (18, 30) dans le circuit électrique ou la tension d'alimentation d'au moins un demi-pont (16) sont commutables individuellement et/ou qu'au moins une mais de préférence toutes les résistances de pont sensibles au champ magnétique (18) présentent une caractéristique de résistance (36) commutable, de telle sorte qu'une commutation d'au moins une caractéristique de résistance, notamment une commutation par paire des caractéristiques des résistances sensibles au champ magnétique (18) associées l'une à l'autre des deux demi-ponts (16) ou une commutation de la disposition des résistances de pont (18, 30) dans le circuit électrique est réalisable dans au moins un demi-pont (16), sachant que, dans un premier état M1, M3, une composante du champ magnétique (34) située dans un plan X/Y (20) du capteur est mesurable et que dans un second état M2, M4, une composante du champ magnétique (24) située dans le sens Z est mesurable.

2. Dispositif capteur de champ magnétique (10) selon la revendication 1, **caractérisé en ce que** les résistances de pont sensibles au champ magnétique (18) sont des résistances AMR, GMR ou TMR.

3. Dispositif capteur de champ magnétique (10) selon une des revendications précédentes, **caractérisé en ce qu'**au moins une unité de commutation de prémagnétisation comprend notamment un conducteur de basculement qui peut basculer, c.-à-d. inverser une aimantation interne, pour définir la caractéristique de résistance (36) d'au moins une résistance de pont sensible au champ magnétique (18).

4. Dispositif capteur de champ magnétique (10) selon une des revendications précédentes, **caractérisé en ce que** toutes les résistances (30) du pont de mesure de Wheatstone (14) sont des résistances sensibles au champ magnétique (18).

5. Dispositif capteur de champ magnétique (10) selon une des revendications précédentes, **caractérisé en ce que** deux ponts de mesure de Wheatstone (14a, 14b) sont comprises, sachant que l'orientation des composantes du champ magnétique (34) des deux ponts de mesure (14a, 14b), qui sont sensibles à la mesure et situées dans le plan X/Y (20) du capteur de champ magnétique est orthogonale.

6. Dispositif capteur de champ magnétique (10) selon une des revendications précédentes, **caractérisé en ce que** l'élément ferromagnétique de concentration de flux (22) est constitué de fer, cobalt, nickel, d'un alliage ferromagnétique tel que AlNiCo, SmCo, Nd2Fe14B, Ni80Fe20, alliage NiFeCo ou d'une combinaison de ces éléments.

7. Dispositif capteur de champ magnétique (10) selon une des revendications précédentes, **caractérisé en ce que** l'élément ferromagnétique de concentration de flux (22) présente une forme symétrique, notamment par symétrie spéculaire ou symétrie de révolution, notamment une forme rectangulaire, notamment une forme carrée dans le plan X/Y (20) du capteur de champ magnétique, forme dans laquelle de préférence les bords latéraux de l'élément de concentration de flux (22) sont orientés dans le sens X/Y.

8. Dispositif capteur de champ magnétique (10) selon une des revendications précédentes, **caractérisé en ce qu'**une surface supérieure ou une surface inférieure de l'élément de concentration de flux (22) se situe dans le plan X/Y (20) du capteur de champ magnétique.

9. Procédé pour déterminer deux ou trois composantes d'un champ magnétique au moyen d'un dispositif capteur de champ magnétique (10) selon une des revendications précédentes, **caractérisé en ce qu'**une commutation d'au moins une caractéristique de résistance, notamment une commutation par paire des caractéristiques des résistances des deux demi-ponts (16) qui sont sensibles au champ magnétique (18) et associées l'une à l'autre ou une commutation de la disposition des résistances de pont (18, 30) dans le circuit électrique a lieu dans au moins un demi-pont (16), sachant que, dans un premier état M1, M3, une composante du champ magnétique (34) située dans X/Y est mesurable au moyen de courbes en sens opposé de résistances de pont (18) sensibles au champ magnétique et correspondant entre elles, et dans un second état M2, M4, une composante du champ magnétique (24) située dans le sens Z est mesurable au moyen de courbes de même sens de résistances de pont (18) sensibles au champ magnétique et correspondant entre elles, de sorte qu'une composante du champ magnétique (34) située dans le plan X/Y provoque dans les deux demi-ponts (16) une variation de tension U1, U2 d'une première grandeur de variation sur la prise médiane du demi-pont (16) et qu'une composante du champ magnétique (24) située dans le sens Z perpendiculaire au plan X/Y du capteur provoque une variation de tension différente d'une seconde grandeur de variation.

10. Procédé selon la revendication 9, **caractérisé en ce qu'**une commutation des états a lieu dans l'ordre M1, M2, M1, et M2 ou M1, M2, M3 et M4.

11. Procédé selon la revendication 9 ou 10, **caractérisé en ce qu'**un décalage de tension du pont de mesure (14) est éliminé par filtrage à l'aide d'une unité d'analyse.
